# EUROPÄISCHE PATENTSCHRIFT

(11) **EP 4 484 905 B1**
(45) Veröffentlichungstag und Bekanntmachung des Hinweises auf die Patenterteilung: **06.08.2025**
(21) Anmeldenummer: 24184506.4
(22) Anmeldetag: 25.06.2024
(51) Int. Cl.: G01G 19/393, G06F 30/20

(54) **VORRICHTUNG UND VERFAHREN ZUR AUSWAHL EINER WAAGE UND SIMULATION DES BETRIEBSVERHALTENS EINER WAAGE, INSBESONDERE KOMBINATIONSWAAGE, MITTELS EINES DIGITALEN MODELLS UND NUMERISCHER SIMULATION**
DEVICE AND METHOD FOR SELECTING A BALANCE AND SIMULATING THE OPERATING BEHAVIOR OF A BALANCE, IN PARTICULAR COMBINATION BALANCE, BY MEANS OF A DIGITAL MODEL AND NUMERICAL SIMULATION
DISPOSITIF ET PROCÉDÉ DE SÉLECTION D'UNE BALANCE ET SIMULATION DU COMPORTEMENT DE FONCTIONNEMENT D'UNE BALANCE, EN PARTICULIER BALANCE COMBINÉE, AU MOYEN D'UN MODÈLE NUMÉRIQUE ET SIMULATION NUMÉRIQUE

(30) Priorität: 26.06.2023 DE 202023103530 U
(43) Veröffentlichungstag der Anmeldung: 01.01.2025
(73) Patentinhaber: MULTIPOND Wägetechnik GmbH, 84478 Waldkraiburg (DE)
(72) Erfinder: HARTMANN, Julia, 86199 Augsburg (DE); PETERS, Andreas, 84544 Aschau am Inn (DE); PROFE, Felix, 84543 Winhöring (DE); SPATENEDER, Markus, 84568 Pleiskirchen (DE); JOCHIM, Stanislav, 84431 Heldenstein (DE); VILISOV, Jurij, 84478 Waldkraiburg (DE); WALDHÖR, Felix, 84367 Reut (DE); ZECK, Wolfram C., 84453 Mühldorf (DE)
(74) Vertreter: Prüfer & Partner mbB Patentanwälte · Rechtsanwälte

(56) Entgegenhaltungen:
- US-A1- 2018 274 969

## Beschreibung

Die vorliegende Erfindung beschäftigt sich mit einer Simulation des Betriebs einer Waage, insbesondere Kombinationswaage, mit Hilfe eines digitalen Modells einer Waage und deren Unterbestandteile sowie einer numerischen Simulation, insbesondere einer Produktsimulation. Ferner ist die vorliegende Erfindung auf eine Simulationsvorrichtung ausgerichtet, mit welcher das Betriebsverhalten einer Waage, insbesondere Kombinationswaage, sowie der an diese angeschlossenen Fördereinrichtungen simuliert werden kann. Somit können Waagen und Waagenteile angepasst an geforderte Parameter und Kundenwünschen ausgewählt, angepasst und optimiert werden.

Die numerische Simulation kann beispielsweise eine DEM-Simulation (Diskrete Elemente Methoden - Simulation), FEM-Simulation (Finite Elemente Methoden-Simulation), MKS (Mehrkörpersimulation) sein. Die numerische Simulation kann kombiniert mit lernfähigen Verfahren für dynamische Prozesse und Zeitreihen sein, z.B. einem Nonlinear autoregressive exogenous model (NARX), Long Short-Term Memory (LSTM), Reinforcement Learning (RL) und/oder Iterative Learning Control (ILC).

Im Stand der Technik ist aus dem Dokument EP 1 166 057 B1 eine Kombinationswaage bekannt. Hier werden Produkte aus einer Verteilvorrichtung durch Zuführen gefördert, bevor diese in entsprechende Vorratsbehälter bzw. dann in entsprechende Wägebehälter fallen. Anschließend werden Produkte von einer Sammeleinrichtung aufgefangen. Wichtig für entsprechende Vorrats - bzw. Wägebehälter sind insbesondere die Zargen, also die Grundkörper der entsprechenden Vorrats- oder Wägebehälter, da diese die zu wiegenden Produkte auffangen und - wenn als Wägebehälter verwendet wird - in diesen auch der Wägevorgang durchgeführt wird.

Ferner ist aus dem Dokument DE 44 04 897 A1 eine Teilmengenkombinationswaage bekannt. Diese dient zum Erstellen einer Gesamtgewichtsmenge aus verschiedenen Teilmengen, mit Schwingförderrinnen, den Schwingförderrinnen nachgeschalteten Vorbehältern, einer beliebigen Anzahl Einzelwaagen mit Wägebehältern, die den Vorbehältern nachgeschaltet sind, Lagerbehältern zum Zwischenlagern von bereits erwogenen und in einer gemeinsamen Steuer- und Kontrollvorrichtung registrierten Teilmengen, und einer Sammeleinrichtung.

Bei einer Kombinationswaage müssen, insbesondere in der Lebensmittelindustrie und lebensmittelverarbeitenden Industrie, stets umfangreiche Tests durchgeführt werden, ob eine bestimmte Waage für den Handhabung bestimmter Produkte geeignet ist, und im Anschluss muss bestimmt werden, wie entsprechende Steuerparameter ausgewählt werden müssen. Häufige Probleme bei Kombinationswaagen sind beispielsweise Produktstaus in Teilen der Waage, insbesondere Verklumpungen von Produkten, Produktanhäufungen oder sonstige Störungen. Dies kann insbesondere bei klebrigen Produkten passieren, wie beispielsweise bei Kaubonbons, Gummibärchen, Fleischstücken oder anderen Produkten. Auch können längliche Produkte Probleme verursachen, wenn sich diese beispielsweise in Teilen der Waage verkeilen. Dies ist beispielsweise bei Schokoladenriegeln oder Packungen von Kaubonbons der Fall. Bei der Konfiguration und bei der Herstellung einer solchen Waage müssen daher für die Produkte, welche später mit einer solchen Waage gewogen werden sollen, umfangreiche Tests durchgeführt werden, so dass einerseits die am besten geeignete Waage und Waagenkonfiguration und andererseits die am besten geeigneten Betriebsparameter gefunden werden können mit dem Ziel, dass die Waage für einen bestimmten Anwendungsfall optimal und störungsfrei arbeiten kann. Eine solche Auswahl einer Waage einerseits und die entsprechende Einstellung sowie die Auswahl von Steuerparametern andererseits bedeuten erhöhten Arbeitsaufwand und somit hohe Kosten.

Es ist daher eine Aufgabe der vorliegenden Erfindung, ein Verfahren sowie eine Einrichtung bereitzustellen, die es ermöglichen, dass eine Auswahl und Anpassung einer Waage auf bestimmte Produkttypen schnell und möglichst kostengünstig durchgeführt werden kann.

Diese Aufgabe wird von einem Verfahren zur Konfiguration einer Waage gemäß Anspruch 1 sowie einer Simulationsvorrichtung gemäß Anspruch 10 gelöst.

Weitere
vorteilhafte Ausgestaltungen der vorliegenden Erfindung sind Gegenstand der Unteransprüche.

Ein erfindungsgemäßes Verfahren zur Konfiguration einer Waage, insbesondere Kombinationswaage, weist die folgenden Schritte auf:
a) Bereitstellen eines digitalen Modells einer Grundkonfiguration der Waage sowie eines initialen Steuerdatensatzes der Waage;
b) Bereitstellen von Daten der zu transportierenden Produkte;
c) numerische Simulation der Bewegung von Produkten über den Transportpfad der Waage;
d) Anpassen und/oder Optimieren des digitalen Modells der Waage, basierend auf Ergebnissen der numerischen Simulation;
e) Ausgabe des angepassten und/oder optimierten digitalen Modells der Waage.

In Schritt a) kann ein digitales Modell einer geeigneten Waage bereitgestellt werden, beispielsweise ausgehend von Kundenwünschen. Es kann hier eine Rolle spielen, wie viele Takte pro Minute realisiert werden sollen, wie das Nennfüllgewicht ist, welche Genauigkeiten in der Waage erforderlich sind, wie viel Platz für die Waage vorhanden ist (insbesondere welche Höhe), welche Hygienevorschriften gelten, wie ggf. die behördlichen Auflagen und Umweltbedingungen sind, wie das *return of investment* sein soll usw. Ferner spielt es eine Rolle, welcher Produktdurchsatz der Waage gefordert ist, d.h. wieviel Produkte pro Zeiteinheit sicher gewogen werden können. Bei der Konstruktion kann es wichtig sein, dass die ganze Waage oder Baugruppen davon anhand Anforderungen an die Lebensdauer konstruiert werden. Für die Wartung der Waage müssen relevante Messgrößen identifiziert werden. Das digitale Modell umfasst vorwiegend geometrische Abmessungen der Waage sowie der Waagenteile. Der initiale Steuerdatensatz umfasst beispielsweise Vibrationsfrequenzen und Vibrationsamplituden von Teilen der Waage, welche Produkt transportieren.

Das digitale Modell kann aber auch ein physikalisches Modell (White-Box: Gleichungen..), neuronales Netz (Black-Box) oder hybrides Modell (Grey-Box) umfassen.

In Schritt b) werden Produktdaten bereitgestellt - dies können geometrische Abmessungen, aber auch Stückgewicht, Oberflächeneigenschaften, Reibungskoeffizienten etc. des Produkts sein.

Ferner können folgende Parameter zu den Produktdaten gehören: das Produktvolumen, das spezifische Formverhältnis, die Orientierung im Raum, die Eigenbewegung (Rotation, Rollreibung, Massenschwerpunkt, Trägheitsparameter,...), die Dichte, die Schüttdichte, das Schüttgewicht, das Stückgewicht, die Elastizität, die Verformbarkeit, das E-Modul, die Querkontraktionszahl, die Härte, die Haftreibung, die Gleitreibung, die Abriebeigenschaften, die Oberflächenrauheit, die magnetischen Eigenschaften, die elektrischen Eigenschaften, die thermischen Eigenschaften wie Wärmeleitfähigkeit und Schmelzpunkt, der Produktpreis, die Toxizität, die Staubexplosionsklasse usw.

In Schritt c) wird eine numerische Simulation der Bewegung von Produkten über den Transportpfad der Waage durchgeführt (also eine Produktverhaltenssimulation)-dabei wird eine bestimmte Anzahl an Produkten für die Simulation verwendet. So kann festgestellt werden, ob die Bewegung der Produkte homogen verläuft, oder ob evtl. Produktstaus, Verkeilungen oder sonstige Störungen auftreten, welche den Produktdurchsatz der Waage negativ beeinflussen könnten.

Hierbei kann das Verhalten des Produktes auf diversen Oberflächen und unter diversen Bedingungen anhand typischer Parameter (Größe, Reibung, Struktur...) simuliert werden, so wie beispielsweise das Fließverhalten auf Beschickungseinrichtungen, Verteileinrichtungen, Dosierrinnen, Rutschen, Trichtern, Ableitblechen, sowie die Positionierung des Produktes innerhalb von Behältern, Leiteinrichtungen usw.

So kann auch die maximale Anzahl von sicher, durch Wiegen zählbaren Produkten anhand numerischer Simulation bestimmt werden. Auch hier kann eine Optimierung erfolgen, d.h. es kann durch Änderungen der geometrischen Eigenschaften von Waagenteilen ein höherer Durchsatz erzielt werden.

In Schritt d) wird das digitale Modell der Waage entsprechend angepasst bzw. optimiert - im digitalen Modell könnten also einzelne geometrische Eigenschaften der Waage verändert werden - es könnte beispielsweise ein Winkel oder eine Länge einer Dosierrinne geändert werden.

Zudem kann eine Berechnung / Änderung der konstruktiven Maße von Baugruppen der Waage anhand des Verhaltens des digitalen Modells der Waage und der numerischen Simulation erfolgen - so kann beispielsweise die Form einer Beschickungsvorrichtung, eines Verteiltellers, von Dosierrinnen, Vorratsbehältern, Wägebehältern, Sammelbehältern, Rutschen, Trichtern und sonstigen Teile der Produktführung (z. B. Stopper, Ableitbleche, Schikanen) berechnet und optimiert werden. Der Fokus dieser Erfindung liegt auf der Optimierung der Waage selbst.

Zudem können optional im Steuerdatensatz bzw. Steuer- und Regeldatensatz für einzelne Teile der Waage, wie z.B. den Verteilteller, höhere Vibrationsamplituden eingestellt werden. Es können hier eine Vielzahl von Änderungen vorgenommen werden, und für alle Kombinationen von Änderungen kann die numerische Simulation wiederholt werden, bis ein optimaler Zustand gefunden wird.

Die Schritte c) und d) können also beliebig oft wiederholt werden.

In Schritt e) wird das optimierte digitale Modell der Waage ausgegeben. Dieses kann nun für eine reale Waage verwendet werden.

So kann eine Waage konfiguriert werden, und es kann an einer realen Waage (beispielsweise bei der Installation oder bei der Abnahme) der Betrieb ohne umfangreiche Vorexperimente aufgenommen werden, lediglich mit einem initialen oder optional simulierten Steuerdatensatz. Parameter der Steuerung können optional mit der numerischen Simulation für die gewünschte Produktverteilung angepasst werden, es wird hier sozusagen ein quasi realer Modus gefahren. Ferner können Ausgangsparameter des quasi realen Betriebs festgehalten werden, ein späterer Vergleich im realen Betrieb der Waage erlaubt es dann, etwaige Abweichungen aufzuspüren und damit die Parameter des digitalen Modells und der numerischen Simulation anzupassen.

Auch können anhand der Kopplung von numerischer Simulation und optionalen Optimierung auch eines Steuerdatensatzes im Betrieb einer realen Waage neue Baugruppen hinzugefügt werden, beispielsweise kann hier eine Schwenktrichtereinheit eines Übergabesystems für die Waage neu angepasst werden. Schwankungen können von der numerischen Simulation generiert und die Auswirkung auf die neue Baugruppe getestet werden, und nötige Parameter für den Betrieb der neuen Baugruppe, wie beispielsweise des Übergabesystems, können daraus ermittelt werden.

Dies betrifft beispielsweise die Verweilzeit und die Schwenkzeit eines Schwenktrichters eines Produktübergabesystems.

Vorzugsweise sind in Schritt a) die Grundkonfiguration der Waage die geometrischen Abmessungen der Waage bzw. Teilen der Waage, und/oder die Oberflächeneigenschaften der Waage bzw. Teilen der Waage. Es können hier also von sämtlichen Bauteilen der Waage die geometrischen Abmessungen, beispielsweise mit Hilfe einer CAD-Datei, hinterlegt werden, und auch die Oberflächeneigenschaften, wie beispielsweise Gleitreibungskoeffizienten und Haftreibungskoeffizienten, können entsprechend hinterlegt werden. Ferner können Umgebungseigenschaften der Waage wie z.B. Temperatur, Luftdruck hinterlegt werden.

So kann beispielsweise das Produktverhalten von klebrigen Produkten umfangreich getestet werden, ohne dass hier ein aufwändiges Experiment mit einer größeren Menge an klebrigem Produkt durchgeführt werden müsste. Auch können beispielsweise Elastizitätsmodule der Produkte hinterlegt sein, wie beispielsweise bei Salatblättern usw. Auch können zulässige Spannungen hinterlegt sein, welcher im Produkt vorliegen können, ohne dass dieses reißt oder bricht - beispielsweise bei Tiefkühl-Pommes, Croissants, Keksen usw.

Optional kann die Grundkonfiguration der Waage Umgebungseigenschaften der Waage beinhalten, wie beispielsweise die Temperatur oder die Luftfeuchtigkeit, Vibrationen oder Geschwindigkeiten von Wind, Luftzügen usw.. So können in einem gewissen Bereich auch andere Umgebungsbedingungen simuliert werden, welche später beim Betrieb der Waage auftreten können, wie beispielsweise durch erhöhte Sonneneinstrahlung, das Auftreten von Wolken, Beschattung der Waage, Wind durch das Öffnen von Hallentüren, Betrieb eines Ventilators oder dem Vorbeifahren großer Transportmittel. Auch Vibrationen oder, Schwingungen anderer Anlagenteile (Steilförderer, Förderbänder, Pressen, Pelletieranlagen...) können eine Rolle spielen. So können mit Hilfe der Simulation die Auswirkung von Änderung der Umweltfaktoren auf die internen Steuerparameter entsprechend berechnet werden. Auch kann so das Produktverhalten untersucht werden, wie beispielsweise die Änderung der Produkteigenschaften bei Sonneneinstrahlung von Tiefkühl-Pommes, Schokoladenriegeln oder sonstigen Lebensmitteln.

Es können so - ohne aufwändige Experimente - mehrere Betriebsbedingungen getestet werden, welche im späteren Betrieb der Waage auftreten könnten. Für diese Betriebsbedingungen könnten dann auch optional angepasste Steuerparameter hinterlegt werden.

Die Temperatur als Parameter ist beispielsweise abhängig von: Sonneneinstrahlung ab einer bestimmten Zeit, Sonneneinstrahlung beim Verschwinden von Wolken, Sonneneinstrahlung nur einseitig, Beschattung durch weitere, bewegliche Anlagenteile.

Vorzugsweise umfasst der Transportpfad der Waage eine Beschickungsvorrichtung und/oder einen Verteilteller und/oder mindestens eine Dosierrinne und/oder mindestens einen Vorratsbehälter und/oder mindestens einen Wägebehälter und/oder mindestens eine Rutsche und/oder einen Trichter und/oder mindestens einen Sammelbehälter und/oder eine Produkt-Leitvorrichtung. Dies sind alles Bauteile mit geometrischen Eigenschaften, welche im digitalen Modell entsprechend hinterlegt werden können. Oberflächeneigenschaften der einzelnen Bauteile können sich auch unterscheiden. Weiter vorzugsweise kann der Transportpfad der Waage noch Stopper und/oder Ableitbleche umfassen. Innerhalb der numerischen Simulation können geometrische Eigenschaften, Oberflächeneigenschaften usw. dieser Bauteile auch entsprechend geändert werden, und es kann überprüft werden, welche Auswirkung die Änderungen auf den Produktfluss haben können. So können einzelne Teile der Waage optimiert werden.

Vorzugsweise hat eine Beschickungsvorrichtung einen Beschickungsvorrichtungsantrieb, ein Verteilteller einen Verteilertellerantrieb, eine Dosierrinne einen Dosierungsantrieb und eine Produkt-Leitvorrichtung einen Produkt-Leitvorrichtungs-Antrieb. Weiter vorzugsweise hat ein Vorratsbehälter mindestens eine Vorratsbehälterklappe, ein Wägebehälter hat mindestens eine Wägebehälterklappe, und ein Sammelbehälter hat mindestens eine Sammelbehälterklappe. Im Steuerdatensatz sind entsprechende Betriebsparameter dieser Teile umfasst. Alle Teile können auch mehrfach vorhanden sein. Es können natürlich auch noch mehr Antriebe vorhanden sein, beispielsweise für Klappen.

Vorzugsweise werden in Schritt c) Bohrungstoleranzen, Längentoleranzen und/oder Lagetoleranzen) bei der Simulation berücksichtigt. Das bedeutet, dass sämtliche Kombinationen von Verschiebungen der Bauteile (beispielsweise zwei Bauteile, welche mit einer Schraube und Bohrungen verbunden sind) simuliert werden, und es kann überprüft werden, ob so Ereignisse entstehen können, welche den Produktfluss stören könnten. So kann das Verhalten des digitalen Modells getestet werden, wenn alle Toleranzschwankungen sich innerhalb der erlaubten Grenzen bewegen. Auch kann überprüft werden, ob so Schwingungen bzw. Resonanzen in bestimmten Betriebssituationen entstehen könnten. Auch könnte beispielsweise der Einfluss von Toleranzen von elektrischen Bauteilen (MOSFETs, Dioden, Übergangswiderstände, usw.) simuliert werden und so eine erhöhte Verlustleistung und einer Reduzierung der Lebensdauer festgestellt werden. Auch kann so festgestellt werden, ob lokale Überhitzungen auftreten könnten, welche sensible Waagenteile bzw. Produkte schädigen könnten. Auch intern auftretende oder externe Resonanzen und/oder Schwingungen in bestimmten Betriebssituationen können berücksichtigt werden.

In Schritt b) werden vorzugsweise charakteristische Produkteigenschaften, vorzugsweise geometrische Abmessungen von Produkten und/oder Oberflächeneigenschaften von Produkten und/oder Reibungseigenschaften von Produkten bereitgestellt. Dadurch ist es möglich, ein Produkt mit mehreren Parametern zu charakterisieren, welche wichtig für das Transportverhalten des Produktes sind. Auch könnten hier elastische Eigenschaften der Produkte eine Rolle spielen, d.h. ob ein bestimmtes Produkt gequetscht werden kann, ohne dabei beschädigt oder zerstört zu werden.

Vorzugsweise kann in Schritt d) die Grundkonfiguration der Waage optional auch der Steuerdatensatz der Waage, basierend auf simuliertem Produktverhalten, vorzugsweise simulierter Produktgeschwindigkeit, simulierter Homogenität des Produktflusses und/oder der simulierten Wahrscheinlichkeit des Auftretens von Produktstau optimiert werden. Dies bedeutet, dass die Geometrien von Teilen der Waage und/oder der Steuerdatensatz der Waage entsprechend verändert werden, und dann überprüft wird, welche Auswirkungen bestimmte Änderungen auf eine Produktgeschwindigkeit, die Homogenität des Produktflusses oder der Wahrscheinlichkeit des Auftretens von Produktstau haben kann. So kann sichergestellt werden, dass die Waage mit simulierten Parametern betrieben wird, bei welchen die Möglichkeit des Auftretens eines Produktstaus minimiert wird.

Es können hier beispielsweise Kriterien definiert werden, welche eingehalten werden müssen, wie beispielsweise der störungsfreie Betrieb einer Waage (d.h. ohne Produktstaus) für eine bestimmte Zeitspanne.

Der Steuerdatensatz der Waage umfasst optional mindestens einen der folgenden Parameter:
- Vibrationsamplitude des Verteiltellerantriebs
- Vibrationsfrequenz des Verteiltellerantriebs
- Drehgeschwindigkeit des Verteiltellerantriebs
- Vibrationsamplitude mindestens eines Dosierrinnenantriebs
- Vibrationsfrequenz mindestens eines Dosierrinnenantriebs
- Öffnungszeit und Öffnungsdauer der mindestens einen Vorratsbehälterklappe
- Öffnungszeit und Öffnungsdauer der mindestens einen Wägebehälterklappe
- Öffnungszeit und Öffnungsdauer der mindestens einen Sammelbehälterklappe
- Bewegungsabläufe von einer Produkt-Leitvorrichtung.

Es können natürlich auch noch mehr Parameter umfasst sein, beispielsweise Vibrationsamplitude und Vibrationsfrequenz der Beschickungseinrichtung, die Drehdauer und Drehrichtung des Verteiltellers, ferner Dosierzeiten der Behälter. Es kann auch das Bewegungsprofil einzelner Waagenteile erhalten sein (also die zeitliche Abfolge von Bewegungen, also z. B. erst langsame Bewegung des Verteiltellers, dann schnellere Bewegung...).

So sind genügend Möglichkeiten vorhanden, die Waagensteuerung zu ändern, um so mit der Simulation festzustellen, ob die Wahrscheinlichkeit von Produktstaus erhöht oder gesenkt werden kann.

Es können beliebig viele Parameterkombinationen simuliert werden, und das Verhalten der Waage kann so untersucht werden.

Vorzugsweise werden in Schritt c) N Produkte für die Simulation verwendet (N ist eine ganze Zahl größer als 1). Die Anzahl an Produkten kann möglichst hoch ausgewählt werden, um hier ein möglichst ein robustes Verhalten zu simulieren.

Beispiele der Einflüsse dieser Parameter sind wie folgt:
Die Vibrationsamplitude der Dosierrinne, die Dosierzeit und die Öffnungszeit der Behälter können für die Berechnung der Förderbarkeit bestimmter Produkte anhand der numerischen Simulation verwendet werden. Ferner können optional die Auswirkungen von Änderungen von Steuerstrategien- und -parametern am digitalen Modell validiert werden, und dann in die reale Steuerung übertragen werden.

Auch ein Produktverhalten auf bestimmten Waagenteilen kann getestet werden, beispielsweise auf einer Beschickungseinheit und einem besonders geformten Verteilteller (z.B. gefalteten Verteilteller). Hier können die Auswirkungen unterschiedlicher Befüllungen auf die Fähigkeit der Produkte, sich zu orientieren, untersucht werden (zum Beispiel längliche Produkte entlang der "Faltungstäler" des gefalteten Verteiltellers können dann richtig auf die Dosierrinne fallen oder auch nicht). Ferner kann beispielsweise die Drehgeschwindigkeit eines Verteiltellers derart geregelt werden, dass ein Produkt genau auf eine bestimmte Dosierrinne fällt, zum Beispiel diejenige, welche am leersten ist. Die numerische Simulation kann durch die Anpassung des Parameters "Drehgeschwindigkeit des Verteiltellers" mehrere Szenarien simulieren und validieren. Während der Durchführung des Vorgangs können auch Änderungen in die Simulation einfließen, wie beispielsweise wenn weitere Produkte dazukommen, weitere Dosierrinnen können sich leeren ...), und der Steuerdatensatz kann optional entsprechend angepasst werden.

Ferner könnte beispielsweise eine Drehgeschwindigkeit eines Verteiltellers derart geregelt werden, dass mehrere auf dem Verteilteller befindliche Produkte in eine bestimmte Dosierrinne fallen, um bei der Verteilung dieser Produkte eine möglichst optimale Befüllung aller Dosierrinnen zu erreichen, beispielsweise durch Anpassung und Optimierung des Parameters Drehgeschwindigkeit des Verteiltellers. Die numerische Simulation kann für die Bewegung mehrerer Produkte auf dem Verteilteller mehrere Szenarien simulieren und validieren, und auch während der Durchführung des Vorgangs können Änderungen in die Simulation einfließen, beispielsweise wenn weitere Produkte dazukommen oder weitere Dosierrinnen leer werden. Der Steuerdatensatz kann entsprechend angepasst werden.

Ein weiteres Beispiel für eine optimierte Regelung mit Hilfe von simulierten Steuerparametern ist die Erhöhung der Schwingamplitude der Dosierrinne in Verbindung mit der Reduzierung der Dosierzeit (Öffnungszeiten der Behälterklappen), wegen Änderungen der Produkteigenschaften, wie beispielsweise Verschmutzung der Transportwege durch Abrieb von Produkten usw. Auch kann ein Produktverhalten simuliert werden, wenn beispielsweise die Waage alle Behälter gleichzeitig entleert, was Verstopfungen im weiteren Produktweg (beispielsweise Sammeltrichter) hervorrufen kann. Auch kann simuliert werden, wie die Klebrigkeit (Haftreibung) des Produkts das Klumpen beeinflusst, wie beispielsweise eine unregelmäßige Belegung von Verteilteller und Dosierrinnen auftreten kann, was zu sogenannten "Lücken" bzw. "Tälern" führt. Dies kann zu Überfüllungen, Leerbefüllung, Anhaftungen, Einklemmen von Produkten zwischen den Behältern, und dem Verzug des Produkts beim Fallen führen, was zur Trennung von einzelnen Abwürfen der Behälter führen kann.

Auch kann das digitale Modell in Verbindung mit numerischen Simulationen optional in die komplette Steuerung einer Anlage eingebunden werden, um die Auswirkungen von normalen und abnormalen Betriebszuständen vorherzusehen, um beispielsweise eine erhöhte oder auch verringerte Produktzufuhr bei vorgeschalteten Anlagenteilen, die Änderungen der Produkteigenschaften aufgrund Änderungen der Produktzufuhr, Änderungen im Lüftungskonzept der Halle, in welcher die Maschine steht, Temperaturänderungen in der Halle, Änderungen der Sonneneinstrahlung ab einem bestimmen Ereignis, und eine Verschmutzung von produktführenden Teilen der Waage, zu berücksichtigen. Hier kann beispielsweise eine Kompensation des geänderten Verhaltens simuliert werden, und es können auch bestimmte Ereignisse in die Simulation einfließen, wie beispielsweise eine Reinigung, ein Schwenken von bestimmten Klappen, und/ oder eine Erhöhung der Vibrationsfrequenzen der Amplitude.

Luftzüge können beispielsweise entstehen durch Ventilatoren, Öffnen/Schließen von Hallentoren, Vorbeifahren gr0ßer Transportmittel.

Nach der Simulation können alle relevanten Parameter des digitalen Modells / optional des Steuerdatensatzes beispielsweise in einer Cloud abgelegt werden. Bei neuen Waagen eines ähnlichen Typs oder ähnlichen Produkten kann die Simulation dann mit dem digitalen Modell und den Ergebnissen der optimierten Steuerparameter direkt gestartet werden, und neue Parameter können angepasst werden. Auch können die Parameter anhand einer breiten Datenlage neu korreliert bzw. korrigiert werden. Es kann auch stets ein permanenter Abgleich mit der Realität über Sensoren, Zustandsmeldungen, Fehlermeldungen, Logfiles, und Produktionsergebnissen stattfinden, bzw. mit dem Datenpool von Daten ähnlicher Waagen. So können Simulationsergebnisse validiert werden.

Eine erfindungsgemäße Simulationsvorrichtung weist auf:
eine Eingabevorrichtung, welche dazu angepasst ist, ein digitales Modell einer Grundkonfiguration der Waage, einen initialen Steuerdatensatzes der Waage sowie Daten der zu transportierenden Produkte einzulesen;
eine Recheneinheit, welche dazu angepasst ist, das Verhalten eines zu transportierenden Produkts in Anhängigkeit des initialen Steuerdatensatz mit Hilfe von numerischer Simulation zu simulieren, sowie Anpassungen und/oder Optimierungen des digitalen Modells der Waage (optional auch des Steuerdatensatzes) vorzunehmen;
eine Ausgabevorrichtung, welche dazu angepasst ist, ein digitales Modell (optional auch den Steuerdatensatz) auszugeben (welche(r) angepasst und/oder optimiert wurde(n)).

Mit einer solchen Simulationsvorrichtung können die oben dargestellten Vorteile erzielt werden.

Weiter vorzugsweise ist in der Simulationsvorrichtung die Recheneinheit dazu angepasst, das digitalen Modell der Waage und/oder optional den Steuerdatensatz der Waage basierend auf simuliertem Produktverhalten, vorzugsweise simulierter Produktgeschwindigkeit, simulierter Homogenität des Produktflusses und/oder der simulierten Wahrscheinlichkeit des Auftretens von Produktstau zu optimieren. In der Simulationsvorrichtung ist dann ein bestimmter Datensatz vorhanden, welcher entsprechende Ereignisse entsprechend bewerten kann.

Ferner ist vorzugsweise die Eingabevorrichtung dazu angepasst, die geometrischen Abmessungen der Waage bzw. von Teilen der Waage und/oder Oberflächeneigenschaften der Waage bzw. von Teilen der Waage einzulesen. Die genaue Anzahl der Parameter kann hierbei genauer definiert werden.

Vorzugsweise ist die Eingabevorrichtung dazu angepasst, charakteristische Produkteigenschaften, vorzugsweise geometrische Abmessungen von Produkten und/oder Oberflächeneigenschaften von Produkten und/oder Reibungseigenschaften von Produkten einzulesen.

Diese Eigenschaften können wichtig sein, wenn es darum geht, ob und wie Produkte sich verkeilen, aneinanderhaften, oder auf sonstige Art und Weise einen Transportpfad einer Waage blockieren können. Ferner ist die Eingabevorrichtung auch vorzugsweise dazu angepasst, die Umgebungseigenschaften der Waage, wie beispielsweise Temperatur oder Luftfeuchtigkeit, einzulesen.

Auch diese Parameter können Einfluss auf die Produkteigenschaften haben, beispielsweise auf das Verhalten von Tiefkühlpommes oder Schokolade.

Vorzugsweise ist die Eingabevorrichtung dazu angepasst, aus dem digitalen Modell Daten des Transportpfads der Waage einzulesen, wobei der Transportpfad eine Beschickungsvorrichtung und/oder einen Verteilteller und/oder mindestens eine Dosierrinne und/oder mindestens einen Vorratsbehälter und/oder mindestens einen Wägebehälter und/oder mindestens einen Sammelbehälter und/oder mindestens eine Rutsche und/oder einen Trichter und/oder eine Produkt-Leitvorrichtung und/oder Stopper und/oder Ableitbleche enthält. Die Eingabevorrichtung sowie Ausgabevorrichtung sind optional ferner dazu angepasst, als Steuerdatensatz Steuerparameter eines Beschickungsvorrichtungsantriebs einer Beschickungsvorrichtung, eines Verteiltellerantriebs eines Verteiltellers, eines Dosierrinnenantriebs einer Dosierrinne einzulesen bzw. auszugeben, vorzugsweise die Vibrationsfrequenz und die Vibrationsamplitude. In die Eingabevorrichtung können initiale Steuerdatenparameter eingegeben werden, und anhand einer Simulation und/oder Optimierung können optimierte Parameter durch die Ausgabevorrichtung ausgegeben werden, welche nachher in einer realen Waage verwendet werden können.

Optional sind die Eingabevorrichtung sowie die Ausgabevorrichtung dazu angepasst, als Steuerdatensatz Steuerparameter eines Produkt-Leitvorrichtungsantriebs einer Produkt-Leitvorrichtung einzulesen bzw. auszugeben, vorzugsweise die Bewegungsgeschwindigkeit des Produkt-Leitvorrichtungsantriebs.

Optional sind die Eingabevorrichtung sowie die Ausgabevorrichtung ferner dazu angepasst, als Steuerdatensatz Steuerparameter mindestens einer Vorratsbehälterklappe eines Vorratsbehälters, mindestens einer Wägebehälterklappe eines Wägebehalters und/oder mindestens einer Sammelbehälterklappe eines Sammelbehälters einzulesen bzw. auszugeben, vorzugsweise die Öffnungszeit und Öffnungsdauer. Auch diese Werte können initial eingelesen werden, im Rahmen der numerischen Simulation dann entsprechend optimiert werden, so dass diese Werte hinsichtlich Produktfluss, Produktbewegungsgeschwindigkeit oder Wahrscheinlichkeit des Eintretens von Produktstaus entsprechend optimiert werden können.

Es besteht mit dem erfindungsgemäßen Verfahren und der erfindungsgemäßen Simulationseinrichtung auch die Möglichkeit, einen hybriden Betrieb der Waage zu fahren. Hierzu wird ein Teilbereich der Waage als digitales Modell bzw. als numerische Simulation in die reale Steuerung eingebunden.

Beispielsweise erfolgt ein Einfahrbetrieb der realen Waage bei der Endabnahme mit simuliertem Produktverhalten: Die Steuerparameter können über die numerische Simulation an die bei dem Produkt zu erwartenden Produktverteilungssituationen angepasst werden, z.B. die Vibrationsamplituden des Verteiltellers, der Dosierrinnen, die Öffnungszeiten der Behälter, und/oder Fallzeiten. Hier erfolgt sozusagen ein Dauerbetrieb im quasirealen Modus.

Es kann auch das Ziel verfolgt werden, Ausgangsparameter des quasirealen Betriebs (initial pattern) beim Auslieferungszeitpunkt festzuhalten, z.B. Stromformen, Zeiten, Temperaturen, Vibrationen, Akustik. Ein späterer Vergleich mit diesen, erlaubt es Abweichungen aufzuspüren, was für eine Überwachung der Betriebsbedingungen und für das Planen der Wartung von Vorteil sein kann.

Daran kann sich eine Qualifikation von neuen Baugruppen im Rahmen einer komplett simulierten restlichen Waage anschließen: z.B. eine Schwenktrichtereinheit eines Übergabesystems wird mit simulierten, unterschiedlichen Produkten vom digitalen Modell der Waage beschickt. Auftretende Schwankungen werden dann vom digitalen Modell und der numerischen Simulation generiert und die Auswirkung auf das Verhalten der neuen Baugruppe getestet. So können nötige Parameter für den Betrieb ermittelt werden, z.B. eine Verweilzeit/Schwenkzeit eines Schwenktrichters bei vorgegebener Leistung. Problemsituationen können so später leichter erkannt werden.

Bevorzugte Ausführungsformen der vorliegenden Erfindung werden nun unter Bezugnahme auf die beiliegenden Figuren näher erläutert.
- Fig. 1: zeigt einen Flowchart eines Vorgangs, in welchem eine Waage ausgehend von den Kundenwünschen konfiguriert wird.
- Fig. 2: zeigt beispielhaft einen Flowchart eines Prozesses, bei dem die Produktzufuhr zu den Vorratsbehältern an Simulationsergebnisse angepasst geregelt werden kann.
- Fig. 3: zeigt eine schematische Ansicht einer Kombinationswaage.
- Fig. 4: zeigt den Transportpfad des Produkts über einzelne Teile der Waage genauer.
- Fig. 5: zeigt eine schematische Ansicht einer Simulationsvorrichtung.

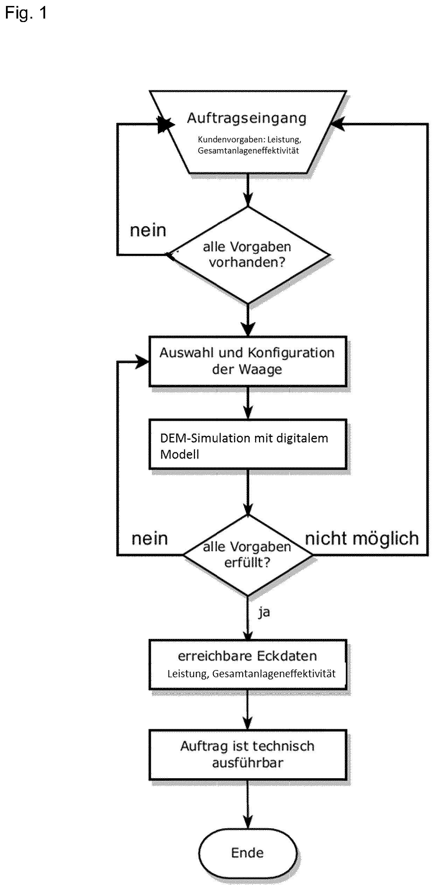

In Fig. 1 ist beispielhaft ein erfindungsgemäßer Konfigurationsvorgang einer Waage gezeigt. In einem ersten Schritt werden alle Kundenvorgaben, beispielsweise hinsichtlich der gewünschten Leistung der Waage geprüft. Wenn alle Vorgaben vorhanden sind, kann ein Grundgerüst einer bestimmten Waage ausgewählt und konfiguriert werden. Dann erfolgt eine numerische Simulation unter Verwendung eines digitalen Modells. Wenn alle Vorgaben erfüllt sind, werden erreichbare Eckdaten, wie beispielsweise die Leistung, ausgegeben, und es kann entschieden werden, dass der Auftrag technisch ausführbar ist. Wenn nicht alle Vorgaben erfüllt sind, muss bei der Auswahl und Konfiguration der Waage nachgebessert werden, d.h. es müssen nur einige Teile der Waage, und somit auch das digitale Modell verändert werden. Falls eine Simulation nicht möglich ist, kann der Auftrag so nicht ausgeführt werden.

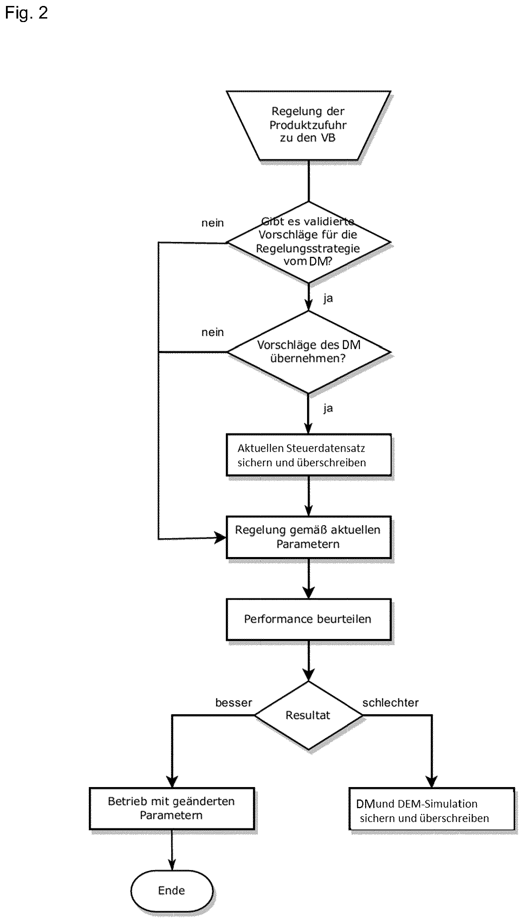

In Fig. 2 ist beispielhaft gezeigt, wie die Regelung der Produktzufuhr zu den Vorratsbehältern entsprechend geregelt werden kann. Hierzu wird zuerst überprüft, ob es validierte Vorschläge für die Regelungsstrategie des digitalen Modells gibt. Wenn dies der Fall ist, werden die Vorschläge des digitalen Modells übernommen, dann werden durch Simulation entsprechende Werte bestimmt, aktuelle Parameter werden gesichert und überschrieben. Wenn dies nicht der Fall ist, muss die Regelung gemäß den aktuellen Parametern erfolgen. Dann muss die entsprechende Leistung der Waage beurteilt werden. Wenn das Ergebnis besser ist als mit den anfänglichen Steuerdaten, dann erfolgt der Betrieb mit geänderten Parametern. Wenn das Resultat schlechter ist als die Eingangswerte, dann müssen das digitale Modell und die numerische Simulation aktualisiert werden, und das System muss neu trainiert werden.

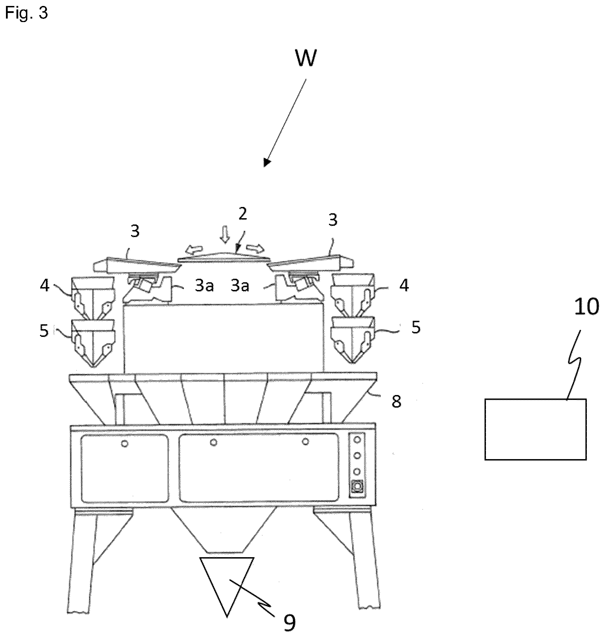

Fig. 3 zeigt schematisch eine Waage W. Hier ist ein Verteilteller 2 zu sehen, von diesem können Produkte auf Dosierrinnen 3 fallen, welche jeweils von Dosierrinnenantrieben 3a angetrieben werden, d.h. in Schwingungen versetzt werden. Aus den Dosierrinnen 3 fallen Produkte in einen Vorratsbehälter 4, von diesem können sie in einen Wägebehälter 5 fallen. Von dort aus werden sie in einem Trichter 8 entsprechend gesammelt, eine Produkt-Leitvorrichtung 9 kann diese noch entsprechend verteilen, nachdem sie den Trichter verlassen haben. Eine Steuereinheit 10 steuert den Betrieb der Waage W.

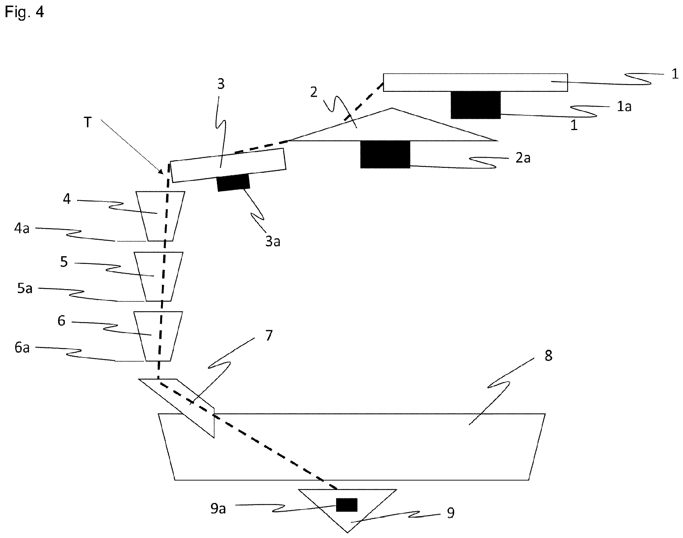

Fig. 4 zeigt einen Transportpfad T über eine Waage beispielhaft. In einer Beschickungsvorrichtung 1 mit einem Beschickungsvorrichtungsantrieb 1a werden Produkte auf einen Verteilteller 2 befördert, dieser weist einen Verteiltellerantrieb 2a auf. Der Verteilteller kann entweder vibrieren, oder sich aber um seine eigene Achse drehen - auch eine Kombination beider Bewegungen ist möglich. Vom Verteilteller 2 fallen Produkte in eine Dosierrinne 3, welche wiederum einen Dosierrinnenantrieb 3a hat, welcher die Dosierrinne 3 in Schwingungen versetzen kann. Unter der Dosierrinne 3 sind ein Vorratsbehälter mit Vorratsbehälterklappen 4a angeordnet, ein Wägebehälter 5 mit Wägebehälterklappen 5a, sowie ein Sammelbehälter mit Sammelbehälterklappen 6a. Zwischen Wegebehälter und Sammelbehälter kann noch ein Verteiltrichter (hier nicht gezeigt) vorgesehen sein. Darunter kann das Produkt in eine Rutsche 7 gelangen, von dort aus in einen Trichter 8, von wo aus es einer Produkt-Leitvorrichtung 9 mit Produkt-Leitvorrichtungsantrieb 9a zugeführt wird, die Produkt-Leitvorrichtung kann das Produkt dann in entsprechende Behälter verteilen.

Alle Elemente können auch mehrfach vorhanden sein, beispielsweise 2 Verteilteller. Die Produkt-Leitvorrichtung 9 kann auch ein komplexes Übergabesystem sein.

Hier wird deutlich, dass die Steuerdaten des Beschickungsvorrichtungsantriebs 1a, des Verteiltellerantriebs 2a, des Dosierrinnenantriebs 3a, der Vorratsbehälterklappen 4a, der Wägebehälterklappen 5a, der Sammelbehälterklappen 6a sowie dem Produkt-Leitvorrichtungsantrieb 9a entsprechend geändert werden können. Dadurch kann das Bewegungsprofil der Produkte entsprechend verändert werden. Die Parameter können entsprechend in verschiedenen Kombinationen simuliert werden, und es kann so festgestellt werden, welches der beste Steuerdatensatz ist, welcher entsprechend zu den wenigsten Produktstaus bzw. andere Störungen führt.

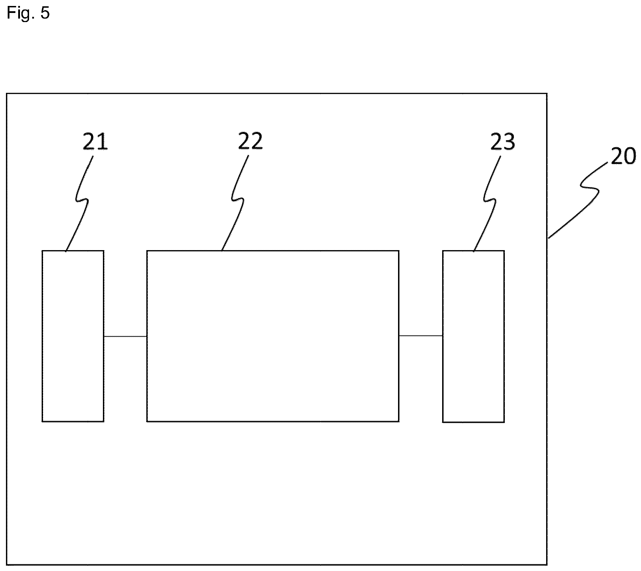

Fig. 5 zeigt schematisch eine Simulationsvorrichtung 20 auf. Diese weist eine Eingabevorrichtung 21, eine Recheneinheit 22 sowie eine Ausgabevorrichtung 23 auf.

### BEZUGSZEICHENLISTE

- W: Waage
- DM: Digitales Modell
- SD: Steuerdatensatz
- P: Produkt
- T: Transportpfad

- 1: Beschickungsvorrichtung
- 1a: Beschickungsvorrichtungsantrieb
- 2: Verteilteller
- 2a: Verteiltellerantrieb
- 3: Dosierrinne
- 3a: Dosierrinnenantrieb
- 4: Vorratsbehälter
- 4a: Vorratsbehälterklappe
- 5: Wägebehälter
- 5a: Wägebehälterklappe
- 6: Sammelbehälter
- 6a: Sammelbehälterklappe
- 7: Rutsche
- 8: Trichter
- 9: Produkt-Leitvorrichtung
- 9a: Produkt-Leitvorrichtungsantrieb
- 10: Steuervorrichtung

- 20: Simulationsvorrichtung
- 21: Eingabevorrichtung
- 22: Recheneinheit
- 23: Ausgabevorrichtung

## Patentansprüche

1. Verfahren zur Konfiguration einer Waage (W), insbesondere Kombinationswaage, **dadurch gekennzeichnet** und aufweisend die folgenden Schritte:
a) Bereitstellen eines digitalen Modells (DM) einer Grundkonfiguration der Waage sowie eines initialen Steuerdatensatzes (SD) der Waage;
b) Bereitstellen von Daten der zu transportierenden Produkte (P);
c) numerische Simulation der Bewegung von Produkten über den Transportpfad (T) der Waage (W);
d) Anpassen und/oder Optimieren des digitalen Modells (DM) der Waage (W), basierend auf Ergebnissen der numerischen Simulation;
e) Ausgabe des angepassten und/oder optimierten digitalen Modells (DM) der Waage.

2. Verfahren gemäß Anspruch 1, wobei in Schritt a) die Grundkonfiguration der Waage (W) die geometrischen Abmessungen der Waage (W) bzw. von Teilen der Waage (W) beinhaltet und/oder Oberflächeneigenschaften der Waage (W) bzw. von Teilen der Waage (W) beinhaltet, und/oder Umgebungseigenschaften der Waage, vorzugsweise die Temperatur und/oder die Luftfeuchtigkeit, beinhaltet.

3. Verfahren gemäß einem der vorhergehenden Ansprüche wobei der Transportpfad (T) der Waage (W) eine Beschickungsvorrichtung (1) und/oder einen Verteilteller (2) und/oder mindestens eine Dosierrinne (3) und/oder mindestens einen Vorratsbehälter (4) und/oder mindestens einen Wägebehälter (5) und/oder mindestens einen Sammelbehälter (6) und/oder mindestens eine Rutsche (7) und/oder einen Trichter (8) und/oder eine Produkt-Leitvorrichtung (9) enthält, und optional auch noch die an die Waage angeschlossenen Fördereinrichtungen enthält, wobei der Transportpfad optional ferner Stopper und/oder Ableitbleche umfasst.

4. Verfahren gemäß Anspruch 3, wobei eine Beschickungsvorrichtung (1) einen Beschickungsvorrichtungsantrieb (1a), ein Verteilteller (2) einen Verteiltellerantrieb (2a), eine Dosierrinne (3) einen Dosierrinnenantrieb (3a) und eine Produkt-Leitvorrichtung (9) einen Produkt-Leitvorrichtungsantrieb (9a) aufweist, und/oder wobei ein Vorratsbehälter (4) mindestens eine Vorratsbehälterklappe (4a), ein Wägebehälter (5) mindestens eine Wägebehälterklappe (5a) und ein Sammelbehälter (6) mindestens eine Sammelbehälterklappe (6a) aufweist.

5. Verfahren gemäß einem der vorhergehenden Ansprüche, wobei in Schritt c) und/oder d) Bohrungstoleranzen, Längentoleranzen und/oder Lagetoleranzen bei der Simulation berücksichtigt werden, sowie daraus resultierende oder extern eingebrachte Resonanzen und/oder Schwingungen in bestimmten Betriebsstiuationen..

6. Verfahren gemäß einem der vorhergehenden Ansprüche, wobei in Schritt b) charakteristische Produkteigenschaften, vorzugsweise geometrische Abmessungen, Gewichte, von Produkten (P) und/oder Oberflächeneigenschaften von Produkten (P) und/oder Reibungseigenschaften von Produkten (P) bereitgestellt werden.

7. Verfahren gemäß einem der vorhergehenden Ansprüche, wobei in Schritt d) die Grundkonfiguration der Waage (W) und/oder der Steuerdatensatz (SD) der Waage basierend auf simuliertem Produktverhalten, vorzugsweise simulierter Produktgeschwindigkeit, simulierter Homogenität des Produktflusses und/oder der simulierten Wahrscheinlichkeit des Auftretens von Produktstau optimiert werden.

8. Verfahren gemäß einem der vorhergehenden Ansprüche, wobei in Schritt c) N Produkte (P) für die Simulation verwendet werden.

9. Simulationsvorrichtung (20) für den Betrieb einer Waage, insbesondere Kombinationswaage, **dadurch gekennzeichnet** und umfassend:
eine Eingabevorrichtung (21), welche dazu angepasst ist, ein digitales Modell (DM) einer Grundkonfiguration der Waage, einen initialen Steuerdatensatzes (SD) der Waage sowie Daten der zu transportierenden Produkte (P) einzulesen;
eine Recheneinheit (22), welche dazu angepasst ist, das Verhalten eines zu transportierenden Produkts (P) in Anhängigkeit des initialen Steuerdatensatz (SD) mit Hilfe von numerischer Simulation zu simulieren, sowie Anpassungen und/oder Optimierungen der Grundkonfiguration der Waage (W) vorzunehmen;
eine Ausgabevorrichtung (23), welche dazu angepasst ist, ein angepasstes und/oder optimiertes digitales Modell auszugeben.

10. Simulationsvorrichtung (20) gemäß Anspruch 9, wobei die Recheneinheit (22) dazu angepasst ist, das digitale Modell (DM) der Waage (W) und/oder den Steuerdatensatz (SD) der Waage basierend auf simuliertem Produktverhalten, vorzugsweise simulierter Produktgeschwindigkeit, simulierter Homogeneität des Produktflusses und/oder der simulierten Wahrscheinlichkeit des Auftretens von Produktstau zu optimieren.

11. Simulationsvorrichtung (20) gemäß Anspruch 9 oder 10, wobei die Eingabevorrichtung (21) dazu angepasst ist, die geometrischen Abmessungen der Waage (W) bzw. von Teilen der Waage (W) und/oder Oberflächeneigenschaften der Waage (W) bzw. von Teilen der Waage (W) einzulesen.

12. Simulationsvorrichtung (20) gemäß einem der Ansprüche 9 bis 11, wobei die Eingabevorrichtung (21) dazu angepasst ist, charakteristische Produkteigenschaften, vorzugsweise geometrische Abmessungen, Gewichte, von Produkten (P) und/oder Oberflächeneigenschaften von Produkten (P) und/oder Reibungseigenschaften von Produkten (P) einzulesen.

13. Simulationsvorrichtung (20) gemäß einem der Ansprüche 9 bis 12, wobei die Eingabevorrichtung (21) dazu angepasst ist, die Umgebungseigenschaften der Waage, beispielsweise die Temperatur und/oder die Luftfeuchtigkeit einzulesen.

14. Simulationsvorrichtung (20) gemäß einem der Ansprüche 9 bis 13, wobei die Eingabevorrichtung (21) dazu angepasst ist, als digitales Modell (DM) Daten des Transportpfads (T) der Waage (W) einzulesen, wobei der Transportpfad (T) eine Beschickungsvorrichtung (1) und/oder einen Verteilteller (2) und/oder mindestens eine Dosierrinne (3) und/oder mindestens einen Vorratsbehälter (4) und/oder mindestens einen Wägebehälter (5) und/oder mindestens einen Sammelbehälter (6) und/oder mindestens eine Rutsche (7) und/oder einen Trichter (8) und/oder eine Produkt-Leitvorrichtung (9) und/oder Stopper und/oder Ableitbleche enthält, und optional noch an die Waage angeschlossene Fördereinrichtungen enthält.

15. Simulationsvorrichtung (20) gemäß einem der Ansprüche 9 bis 14, wobei die Eingabevorrichtung (21) sowie die Ausgabevorrichtung (23) dazu angepasst sind, als Steuerdatensatz (SD) Steuerparameter eines Beschickungsvorrichtungsantriebs (1a) einer Beschickungsvorrichtung (1) , eines Verteiltellerantriebs (2a) eines Verteiltellers (2), eines Dosierrinnenantriebs (3a) einer Dosierrinne (3) einzulesen bzw. auszugeben, vorzugsweise die Vibrationsfrequenz und die Vibrationsamplitude.

## Claims

1. Method for configuring a scale (W), in particular a combination scale, **characterized in that** and comprising the following steps:
a) providing a digital model (DM) of a basic configuration of the scale and an initial control data set (SD) of the scale;
b) providing data of the products (P) to be transported;
c) numerical simulation of the movement of products over the transport path (T) of the scale (W);
d) adapting and/or optimizing the digital model (DM) of the scale (W), based on results of the numerical simulation;
e) outputting the adapted and/or optimized digital model (DM) of the scale.

2. Method according to claim 1, wherein, in step a), the basic configuration of the scale (W) includes the geometric dimensions of the scale (W) or of parts of the scale (W) and/or includes surface properties of the scale (W) or of parts of the scale (W), and/or includes environmental properties of the scale, preferably the temperature and/or the humidity.

3. Method according to one of the preceding claims, wherein the transport path (T) of the scale (W) contains a charging device (1) and/or a distribution plate (2) and/or at least one metering channel (3) and/or at least one storage container (4) and/or at least one weighing container (5) and/or at least one collecting container (6) and/or at least one chute (7) and/or a funnel (8) and/or a product guiding device (9), and optionally also contains the conveying devices connected to the scale, wherein the transport path optionally further comprises stoppers and/or diverter plates.

4. Method according to claim 3, wherein a charging device (1) has a charging device drive (1a), a distribution plate (2) has a distribution plate drive (2a), a metering channel (3) has a metering channel drive (3a) and a product guiding device (9) has a product guiding device drive (9a), and/or wherein a storage container (4) has at least one storage container flap (4a), a weighing container (5) has at least one weighing container flap (5a) and a collecting container (6) has at least one collecting container flap (6a).

5. Method according to one of the preceding claims, wherein, in step c) and/or d), bore tolerances, length tolerances and/or position tolerances , and resonances and/or vibrations resulting therefrom or introduced externally in certain operating situations are taken into account in the simulation.

6. Method according to one of the preceding claims, wherein, in step b), characteristic product properties, preferably geometric dimensions, weights, of products (P) and/or surface properties of products (P) and/or friction properties of products (P) are provided.

7. Method according to one of the preceding claims, wherein, in step d), the basic configuration of the scale (W) and/or the control data set (SD) of the scale are optimized based on simulated product behavior, preferably simulated product speed, simulated homogeneity of the product flow and/or the simulated probability of the occurrence of product jam.

8. Method according to one of the preceding claims, wherein, in step c), N products (P) are used for the simulation.

9. Simulation device (20) for the operation of a scale, in particular a combination scale, **characterized in that** and comprising:
an input device (21) which is adapted to read in a digital model (DM) of a basic configuration of the scale, an initial control data set (SD) of the scale and data of the products (P) to be transported;
a computing unit (22) which is adapted to simulate the behavior of a product (P) to be transported as a function of the initial control data set (SD) with the aid of numerical simulation, and to carry out adaptations and/or optimizations of the basic configuration of the scale (W);
an output device (23) which is adapted to output an adapted and/or optimized digital model (DM).

10. Simulation device (20) according to claim 9, wherein the computing unit (22) is adapted to optimize the digital model (DM) of the scale (W) and/or the control data set (SD) of the scale based on simulated product behavior, preferably simulated product speed, simulated homogeneity of the product flow and/or the simulated probability of the occurrence of product jam.

11. Simulation device (20) according to claim 9 or 10, wherein the input device (21) is adapted to read in the geometric dimensions of the scale (W) or of parts of the scale (W) and/or surface properties of the scale (W) or of parts of the scale (W).

12. Simulation device (20) according to one of the claims 9 to 11, wherein the input device (21) is adapted to read in characteristic product properties, preferably geometric dimensions, weights, of products (P) and/or surface properties of products (P) and/or friction properties of products (P).

13. Simulation device (20) according to one of the claims 9 to 12, wherein the input device (21) is adapted to read in the environmental properties of the scale, for example, the temperature and/or the humidity.

14. Simulation device (20) according to one of the claims 9 to 13, wherein the input device (21) is adapted to read in data of the transport path (T) of the scale (W) as a digital model (DM), wherein the transport path (T) contains a charging device (1) and/or a distribution plate (2) and/or at least one metering channel (3) and/or at least one storage container (4) and/or at least one weighing container (5) and/or at least one collecting container (6) and/or at least one chute (7) and/or a funnel (8) and/or a product guiding device (9) and/or stoppers and/or diverter plates, and optionally also contains conveying devices connected to the scale.

15. Simulation device (20) according to one of the claims 9 to 14, wherein the input device (21) and the output device (23) are adapted to read in or output control parameters of a charging device drive (1a) of a charging device (1), of a distributor plate drive (2a) of a distribution plate (2), of a metering channel drive (3a) of a metering channel (3), as a control data set (SD),
preferably the vibration frequency and the vibration amplitude.

## Revendications

1. Procédé de configuration d'une balance (W), en particulier d'une balance combinée, **caractérisé en ce qu'**il comprend les étapes suivantes :
a) fourniture d'un modèle numérique (DM) d'une configuration de base de la balance ainsi que d'un ensemble de données de commande initial (SD) de la balance ;
b) fourniture de données des produits (P) à transporter ;
c) simulation numérique du mouvement de produits sur le chemin de transport (T) de la balance (W) ;
d) adaptation et/ou optimisation du modèle numérique (DM) de la balance (W) sur la base de résultats de la simulation numérique ;
e) sortie du modèle numérique adapté et/ou optimisé (DM) de la balance.

2. Procédé selon la revendication 1, dans lequel, à l'étape a), la configuration de base de la balance (W) comprend les dimensions géométriques de la balance (W) ou de parties de la balance (W) et/ou comprend des propriétés de surface de la balance (W) ou de parties de la balance (W), et/ou comprend des propriétés environnementales de la balance, de préférence la température et/ou l'humidité de l'air.

3. Procédé selon l'une quelconque des revendications précédentes, dans lequel le chemin de transport (T) de la balance (W) contient un dispositif de chargement (1) et/ou un plateau de distribution (2) et/ou au moins une goulotte de dosage (3) et/ou au moins un réservoir (4) et/ou au moins un récipient de pesée (5) et/ou au moins un récipient collecteur (6) et/ou au moins une goulotte (7) et/ou une trémie (8) et/ou un dispositif de guidage de produit (9), et contient éventuellement également les dispositifs de transport raccordés à la balance, le chemin de transport comprenant facultativement en outre des butées et/ou des déflecteurs.

4. Procédé selon la revendication 3, dans lequel un dispositif de chargement (1) comprend un entraînement de dispositif de chargement (1a), un plateau de distribution (2) comprend un entraînement de plateau de distribution (2a), une goulotte de dosage (3) comprend un entraînement de goulotte de dosage (3a) et un dispositif de guidage de produit (9) comprend un entraînement de dispositif de guidage de produit (9a), et/ou dans lequel un réservoir (4) comprend au moins un clapet de réservoir (4a), un récipient de pesée (5) comprend au moins un clapet de récipient de pesée (5a) et un récipient collecteur (6) comprend au moins un clapet de récipient collecteur (6a).

5. Procédé selon l'une quelconque des revendications précédentes, dans lequel, à l'étape c) et/ou d), des tolérances d'alésage, des tolérances de longueur et/ou des tolérances de position sont prises en compte lors de la simulation, ainsi que des résonances et/ou des vibrations résultantes ou introduites de l'extérieur dans certaines conditions de fonctionnement.

6. Procédé selon l'une quelconque des revendications précédentes, dans lequel, à l'étape b), des propriétés de produit caractéristiques, de préférence des dimensions géométriques, des poids, de produits (P) et/ou des propriétés de surface de produits (P) et/ou des propriétés de frottement de produits (P) sont fournies.

7. Procédé selon l'une quelconque des revendications précédentes, dans lequel, à l'étape d), la configuration de base de la balance (W) et/ou l'ensemble de données de commande (SD) de la balance sont optimisés sur la base d'un comportement de produit simulé, de préférence d'une vitesse de produit simulée, d'une homogénéité simulée du flux de produit et/ou de la probabilité simulée de l'apparition d'un bourrage de produit.

8. Procédé selon l'une quelconque des revendications précédentes, dans lequel, à l'étape c), N produits (P) sont utilisés pour la simulation.

9. Dispositif de simulation (20) pour le fonctionnement d'une balance, en particulier d'une balance combinée, **caractérisé en ce qu'**il comprend :
un dispositif d'entrée (21) qui est adapté pour lire un modèle numérique (DM) d'une configuration de base de la balance, un ensemble de données de commande initial (SD) de la balance ainsi que des données des produits (P) à transporter ;
une unité de calcul (22) qui est adaptée pour simuler le comportement d'un produit (P) à transporter en fonction de l'ensemble de données de commande initial (SD) à l'aide d'une simulation numérique, ainsi que pour effectuer des adaptations et/ou des optimisations de la configuration de base de la balance (W) ;
un dispositif de sortie (23) qui est adapté pour sortir un modèle numérique adapté et/ou optimisé.

10. Dispositif de simulation (20) selon la revendication 9, dans lequel l'unité de calcul (22) est adaptée pour optimiser le modèle numérique (DM) de la balance (W) et/ou l'ensemble de données de commande (SD) de la balance sur la base d'un comportement de produit simulé, de préférence d'une vitesse de produit simulée, d'une homogénéité simulée du flux de produit et/ou de la probabilité simulée de l'apparition d'un bourrage de produit.

11. Dispositif de simulation (20) selon la revendication 9 ou 10, dans lequel le dispositif d'entrée (21) est adapté pour lire les dimensions géométriques de la balance (W) ou de parties de la balance (W) et/ou des propriétés de surface de la balance (W) ou de parties de la balance (W).

12. Dispositif de simulation (20) selon l'une quelconque des revendications 9 à 11, dans lequel le dispositif d'entrée (21) est adapté pour lire des propriétés de produit caractéristiques, de préférence des dimensions géométriques, des poids, de produits (P) et/ou des propriétés de surface de produits (P) et/ou des propriétés de frottement de produits (P).

13. Dispositif de simulation (20) selon l'une quelconque des revendications 9 à 12, dans lequel le dispositif d'entrée (21) est adapté pour lire les propriétés environnementales de la balance, par exemple la température et/ou l'humidité de l'air.

14. Dispositif de simulation (20) selon l'une quelconque des revendications 9 à 13, dans lequel le dispositif d'entrée (21) est adapté pour lire, en tant que modèle numérique (DM), des données du chemin de transport (T) de la balance (W), le chemin de transport (T) contenant un dispositif de chargement (1) et/ou un plateau de distribution (2) et/ou au moins une goulotte de dosage (3) et/ou au moins un réservoir (4) et/ou au moins un récipient de pesée (5) et/ou au moins un récipient collecteur (6) et/ou au moins une goulotte (7) et/ou une trémie (8) et/ou un dispositif de guidage de produit (9) et/ou des butées et/ou des déflecteurs, et contenant éventuellement également des dispositifs de transport raccordés à la balance.

15. Dispositif de simulation (20) selon l'une quelconque des revendications 9 à 14, dans lequel le dispositif d'entrée (21) ainsi que le dispositif de sortie (23) sont adaptés pour lire ou sortir, en tant qu'ensemble de données de commande (SD), des paramètres de commande d'un entraînement de dispositif de chargement (1a) d'un dispositif de chargement (1), d'un entraînement de plateau de distribution (2a) d'un plateau de distribution (2), d'un entraînement de goulotte de dosage (3a) d'une goulotte de dosage (3),
de préférence la fréquence de vibration et l'amplitude de vibration.
